# EUROPEAN PATENT APPLICATION

(11) **EP 3 506 231 A1**
(43) Date of publication of application: **03.07.2019**
(21) Application number: 18195694.7
(22) Date of filing: 20.09.2018
(51) Int. Cl.: G08B 25/14, G06F 17/50

(54) **SYSTEMS AND METHODS FOR GENERATING A ZONE CONFIGURATION AND CAUSE AND EFFECT LOGIC FILES**

(30) Priority: 27.12.2017 US 201715855150
(71) Applicant: Honeywell International Inc., Morris Plains, NJ New Jersey 07950 (US)
(72) Inventor: MEGANATHAN, Deepak Sundar, Morris Plains, NJ 07950 (US); SRIRAMAKRISHNAN, S, Morris Plains, NJ 07950 (US); JANGA, Venugopala Reddy, Morris Plains, NJ 07950 (US)
(74) Representative: Houghton, Mark Phillip

(57) **Abstract**

Systems and methods for generating a zone configuration and associated cause and effect logic files for a security system, a fire alarm system, or a home automation system are provided. Such systems and methods may include automatically using structural details of a building and a respective placement of each of the plurality of devices as identified in a site map file to generate a zone configuration subdividing into a plurality of zones a layout of the building documented in the site map file and generating a respective cause and effect logic file for each of the plurality of zones based on , respective specifications for each of the plurality of devices and the respective placement of each of the plurality of devices with respect to each of the plurality of zones.

## Description

### FIELD

The present invention relates generally to a security system, a fire alarm system, or a home automation system. More particularly, the present invention relates to systems and methods for generating a zone configuration and cause and effect logic files for security devices of the security system, alarm devices of the fire alarm system, or connected devices of the home automation system based on a site map file received by a user interface device of the security system, the fire alarm system, or the home automation system.

### BACKGROUND

Known systems and methods for generating a zone configuration and associated cause and effect logic files for a security system, a fire alarm system, or a home automation system require a user to manually divide a building, region, or site into zones, assign specific devices to those zones based on locations of the devices, and manually enter cause and effect relationships for each of the manually configured zones or for specific ones of the devices. However, known systems and methods do not automatically generate a zone configuration and associated cause and effect logic files based on a site map file received by a user interface device of the security system or the home automation system.

In view of the above, there is a continuing, ongoing need for improved systems and methods.

### BRIEF DESCRIPTION OF THE DRAWINGS

FIG. 1 is a block diagram of a security system, a fire alarm system, or a home automation system in accordance with disclosed embodiments;
FIG. 2 is a view of a window of a user interface device in accordance with disclosed embodiments; and
FIG. 3 is a view of a window of a user interface device in accordance with disclosed embodiments.

### DETAILED DESCRIPTION

While this invention is susceptible of an embodiment in many different forms, there are shown in the drawings and will be described herein in detail specific embodiments thereof with the understanding that the present disclosure is to be considered as an exemplification of the principles of the invention. It is not intended to limit the invention to the specific illustrated embodiments.

Embodiments disclosed herein may include systems and methods for generating a zone configuration and associated cause and effect logic files for a security system, a fire alarm system, or a home automation system. For example, systems and methods disclosed herein may automatically generate a zone configuration subdividing a layout from a site map file of a building into a plurality of zones and generate a respective cause and effect logic file for each of the plurality of zones.

Systems and methods as disclosed herein are described in connection with home automation systems, fire alarm systems, and security systems. It is to be understood that such systems may include, but are not limited to systems that include a control panel in communication with a user interface device and a plurality of security devices, a plurality of alarm devices, and/or a plurality connected devices.

In accordance with disclosed embodiments, a plurality of devices may be deployed throughout the building. In some embodiments, the plurality of devices may include connected devices (e.g. smart thermostat, smart speakers, location sensors, smart switches, etc.) of the home automation system. Additionally or alternatively, in some embodiments, the plurality of devices may include security devices or alarm devices (e.g. fire alarms, smoke sensors, alarm sirens, etc.) of the security system or the fire alarm system. The control panel may be coupled to each of the plurality of devices to receive respective signals therefrom and activate associated outputs of at least some of the plurality of devices, may include a programed processor to interface with each of the plurality of devices, and may be coupled to the user interface device for configuring operation of the control panel with respect to each of the plurality of devices. In some embodiments, the user interface device may be embedded in the control panel. Additionally or alternatively, in some embodiments, the user interface device may be remote from the control panel and connected to the control panel via a wired or wireless medium. In some embodiments, the user interface device may include a computer or mobile device (e.g. a smart phone, tablet, pda, etc.). In some embodiments, the user interface device may include a local thick client. In some embodiments, the user interface device may include a web based thin client.

In accordance with disclosed embodiments, the user interface device may receive the site map file documenting the layout of the building, including at least structural details of the building and a respective placement of each of the plurality of devices within the building. Furthermore, the user interface device may generate the zone configuration subdividing the layout into the plurality of zones using the structural details and the respective placement of each of the plurality of devices identified from the site map file. In some embodiments, the structural details of the building may include walls and other partitions within the building. Furthermore, in some embodiments, the site map file may include a computer aided drafting file, a building information model file, a map file, or an image file.

In accordance with disclosed embodiments, the user interface device may identify respective specifications for each of the plurality of devices. For example, in some embodiments, the respective specifications may detail respective functions and respective features of each of the plurality of devices. Furthermore, the user interface device may generate the respective cause and effect logic file for each of the plurality of zones based on the respective specifications for each of the plurality of devices and the respective placement of each of the plurality of devices with respect to each of the plurality of zones. In some embodiments, the user interface device may transmit the zone configuration and the respective cause and effect logic file for each of the plurality of zones to the control panel, and in some embodiments, the respective cause and effect logic file for each of the plurality of zones may be stored in one or more of a memory of the user interface device and a memory of the control panel. In some embodiments, a single mass data file may contain every respective cause and effect logic file for each of the plurality of zones and may be separately addressable to individually identify the respective cause and effect logic file for each of the plurality of zones. In some embodiments, generating the zone configuration and the respective cause and effect logic file for each of the plurality of zones may be done during a design phase of the building. Providing the configuration during the design phase may allow for easier reworking or adjusting of the plurality of devices within the building in response to the configu ration.

In some embodiments, the user interface device may generate the zone configuration and generate the respective cause and effect logic file for each of the plurality of zones by using security system standards data or fire alarm system standards data. For example, the security system standards data or fire alarm system standards data may include specific requirements for an alert volume of alarms throughout the building and a distance measurement for linking together security zones based on a type of alarm condition. In some embodiments, the fire alarm system standards data may include one of EN54, UL864, and NFPA standards.

In some embodiments, the respective cause and effect logic file for a first of the plurality of zones may link activation of an output type of the plurality of devices for which the respective placement is within a second of the plurality of zones with activation of an input type of the plurality of devices for which the respective placement is within the first of the plurality of zones. In some embodiments, the second of the plurality of zones can be a nearest one of the plurality of zones geographically to the first of the plurality of zones. Additionally or alternatively, the respective cause and effect logic file for the first of the of the plurality of zones may link activation of the output type of the plurality of devices in any of the plurality of zones to activation of the input type of the plurality of devices for which the respective placement is within the first of the plurality of zones. Additionally or alternatively, the respective cause and effect logic file for the first of the of the plurality of zones may link activation of the output type of the plurality of devices for which the respective placement is within a same or adjacent one of the plurality of zones relative to the first of the plurality of zones with activation of the input type of the plurality of devices for which the respective placement is within the first of the plurality of zones.

In some embodiments, the user interface device may automatically generate the zone configuration and the respective cause and effect logic file for each of the plurality of zones in response to receiving the site map file. Additionally or alternatively, the user interface device may automatically generate the zone configuration and the respective cause and effect logic file for each of the plurality of zones in response to receiving user input requesting automatic configuration.

In some embodiments, the user interface device may display a graphical rendering of the site map file that includes an overlay showing each of the plurality of zones and a respective display of information contained within the respective cause and effect logic file for each of the plurality of zones. For example, in some embodiments, the respective display of information may include a listing of each of the plurality of devices for which the respective placement is within an associated one of the plurality of zones. Additionally or alternatively, in some embodiments, the graphical rendering may include recommendations for adding additional devices, moving some of the plurality of devices, or adjusting the zone configuration or the respective cause and effect logic file for some of the plurality of zones.

In some embodiments, the user interface may receive user input altering at least one of the zone configuration or the respective cause and effect logic file for some of the plurality of zones. For example, the user input may include dragging or adjusting boundary boxes for each of the plurality of zones displayed on the user interface device. Additionally or alternatively, in some embodiments, the user interface may receive user input identifying one of the plurality of zones, and in some embodiments, the respective display of information for the one of the plurality of zones may be displayed in response to the user input identifying the one of the plurality of zones, for example, user input received via a display of the graphical rendering. Additionally or alternatively, in some embodiments, the user interface device may receive user input confirming the zone configuration and the respective cause and effect logic file for each of the plurality of zones, responsive to which the user interface device may transmit the zone configuration and the respective cause and effect logic file for each of the plurality of zones to the control panel. Additionally or alternatively, in some embodiments, the user interface device may receive user input indicating a first real world scale for a portion of the site map file and may extrapolate a second real world scale for an entirety of the site map file from the first real world scale.

It is to be understood that the user interface device, the control panel, and each of the plurality of devices as disclosed herein can include a transceiver device and a memory device, each of which can be in communication with control circuitry, one or more programmable processors, and executable control software as would be understood by one of ordinary skill in the art. In some embodiments, the control software can be stored on a transitory or non-transitory computer readable medium, including, but not limited to local computer memory, RAM, optical storage media, magnetic storage media, flash memory, and the like, and some or all of the control circuitry, the programmable processors, and the control software can execute and control at least some of the methods described herein.

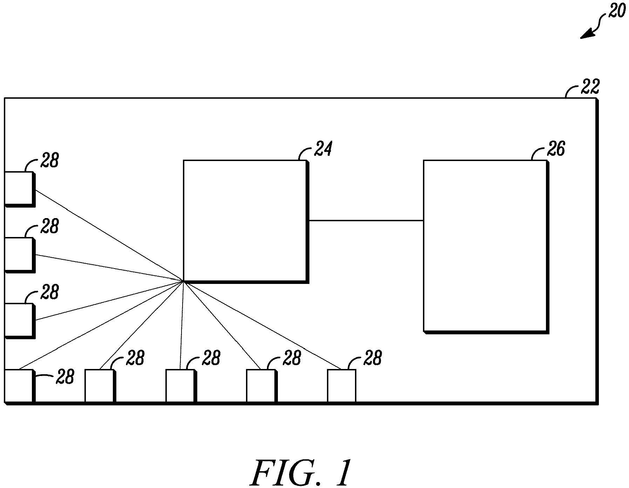

FIG. 1 is a block diagram of a home automation system, a security system, or a fire alarm system, 20 protecting or controlling functions within a building 22. As seen in FIG. 1, the home automation system, the security system, or fire alarm system 20 may include a control panel 24, a user interface device 26 coupled to the control panel 24, and a plurality of devices 28 deployed throughout the building 22.

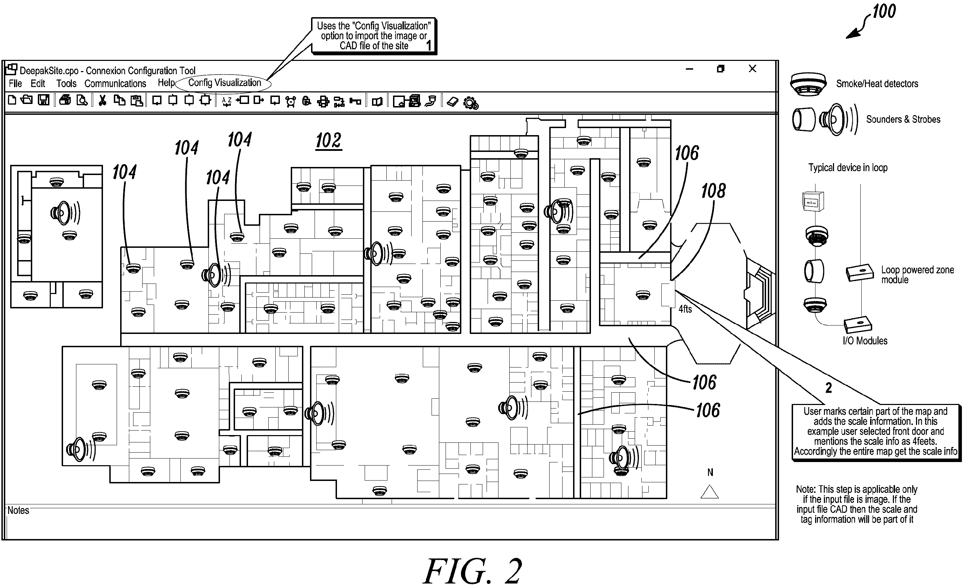

FIG. 2 is a view of a window 100 displayed on the user interface device 26 during a programing phase of the home automation system, the security system, or fire alarm system 20. As seen in FIG. 2, the window 100 may display contents of and extracted from a site map file 102, including a layout of the building 22, graphical icons 104 depicting locations of the plurality of devices 28 within the building 22 and indicating types and/or functions of the plurality of devices 22 and, partitions 106 depicting wall placement and other structural segments that divide the building 22 into a plurality of zones. In some embodiments, the user input device 26 may receive user input adding scale information108 to the site map file 102 and may incorporate the scale information 108 into the all of the site map file 102.

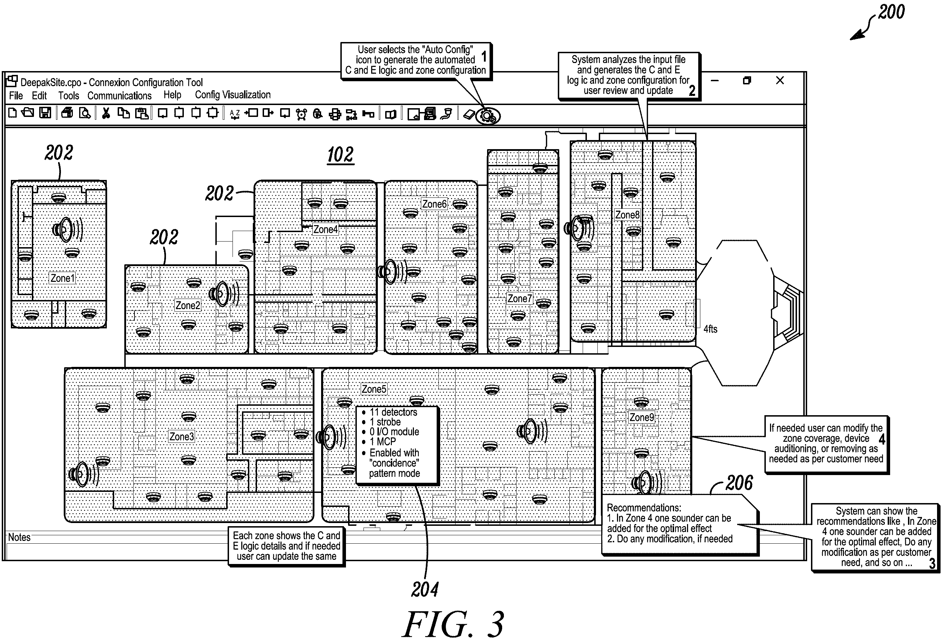

FIG. 3 is a view of a window 200 displayed on the user interface device 26 following activation and completion of an automatic configuration option. As seen in FIG. 3, the window 100 may display one or more of a zone configuration overlay 202 subdividing the building 22 into the plurality of zones, a respective information overlay 204 corresponding to some of the plurality of zones and illustrating details of a respective configuration logic file associated with a respective one of the plurality of zones and/or a respective listing of the plurality of devices 22 deployed within the respective one of the plurality of zones, and a recommendations box 206 that includes recommendations for adding additional devices, moving some of the plurality of devices, or adjusting the zone configuration and the respective cause and effect logic file for some of the plurality of zones.

Although a few embodiments have been described in detail above, other modifications are possible. For example, the steps described above do not require the particular order described or sequential order to achieve desirable results. Other steps may be provided, steps may be eliminated from the described flows, and other components may be added to or removed from the described systems. Other embodiments may be within the scope of the invention.

From the foregoing, it will be observed that numerous variations and modifications may be effected without departing from the spirit and scope of the invention. It is to be understood that no limitation with respect to the specific system or method described herein is intended or should be inferred. It is, of course, intended to cover all such modifications as fall within the spirit and scope of the invention.

The numbered paragraphs below form part of the disclosure of the invention:
1. A method comprising:
   receiving a site map file documenting a layout of a building, the site map file including at least structural details of the building and a respective placement of each of a plurality of devices within the building;
   using the structural details and the respective placement of each of the plurality of devices identified from the site map file to generate a zone configuration subdividing the layout of the building into a plurality of zones;
   identifying a respective specification for each of the plurality of devices;
   generating a respective cause and effect logic file for each of the plurality of zones based on the respective specification for each of the plurality of devices and the respective placement of each of the plurality of devices with respect to each of the plurality of zones; and
   transmitting the zone configuration and the respective cause and effect logic file for each of the plurality of zones to a control panel coupled to each of the plurality of devices.
2. The method of 1 further comprising displaying a graphical rendering of the site map file on a user interface device, the graphical rendering including an overlay illustrating each of the plurality of zones and a respective display of information contained within the respective cause and effects logic file for each of the plurality of zones, and the user interface device being one of a local thick client or a web based thin client.
3. The method of 2 further comprising receiving user input altering at least one of the zone configuration and the respective cause and effect logic file for at least one of the plurality of zones.
4. The method of 2 or 3 further comprising receiving user input confirming the zone configuration and the respective cause and effect logic file for each of the plurality of zones.
5. The method any of 1 to 4 wherein the respective cause and effect logic file for a first of the plurality of zones links activation of an output type of the plurality of devices for which the respective placement is within a second of the plurality of zones with activation of an input type of the plurality of devices for which the respective placement is within the first of the plurality of zones.
6. The method of 5 wherein the second of the plurality of zones is a nearest one of the plurality of zones geographically to the first of the plurality of zones.
7. The method of any of 1 to 6 further comprising using security system standards data or fire alarm system standards data to generate the zone configuration and the respective cause and effect logic file for each of the plurality of zones.
8. The method of any of 1 to 7 further comprising receiving user input indicating a first real world scale for a portion of the site map file and extrapolating a second real world scale for all of the site map file from the first real world scale.
9. The method of any of 1 to 8 wherein the structural details of the building include walls and other partitions within the building.
10. The method of any of 1 to 9 wherein the site map file is one of a computer aided drafting file, a building information model file, a map file, or an image file.
11. A system comprising:
   a plurality of devices deployed throughout a building;
   a control panel coupled to each of the plurality of devices; and
   a user interface device,
   wherein the user interface device receives a site map file documenting a layout of the building,
   wherein the site map file includes at least structural details of the building and a respective placement of each of the plurality of devices within the building,
   wherein the user interface device uses the structural details and the respective placement of each of the plurality of devices identified from the site map file to generate a zone configuration subdividing the layout into a plurality of zones,
   wherein the user interface device identifies a respective specification for each of the plurality of devices,
   wherein the user interface device generates a respective cause and effect logic file for each of the plurality of zones based on the respective specification for each of the plurality of devices and the respective placement of each of the plurality of devices with respect to each of the plurality of zones, and
   wherein the user interface device transmits the zone configuration and the respective cause and effect logic file for each of the plurality of zones to the control panel.
12. The system of 11 wherein the user interface device displays a graphical rendering of the site map file, the graphical rendering including an overlay illustrating each of the plurality of zones and a respective display of information contained within the respective cause and effect logic file for each of the plurality of zones, and wherein the user interface device includes one of a local thick client or a web based thin client.
13. The system of 12 wherein the user interface device receives user input altering at least one of the zone configuration and the respective cause and effect logic file for at least one of the plurality of zones.
14. The system of 12 or 13 wherein the user interface device receives user input confirming the zone configuration and the respective cause and effect logic file for each of the plurality of zones.
15. The system of any 11 to 14 wherein the respective cause and effect logic file for a first of the plurality of zones links activation of an output type of the plurality of devices for which the respective placement is within a second of the plurality of zones with activation of an input type of the plurality of devices for which the respective placement is within the first of the plurality of zones.
16. The system of 15 wherein the second of the plurality of zones is a nearest one of the plurality of zones geographically to the first of the plurality of zones.
17. The system of any of 11 to 16 wherein the user interface device uses security system standards data or fire alarm system standards data to generate the zone configuration and the respective cause and effect logic file for each of the plurality of zones.
18. The system of any of 11 to 16 wherein the user interface device receives user input indicating a first real world scale for a portion of the site map file and extrapolates a second real world scale for all of the site map file from the first real world scale.
19. The system of any of 11 to 18 wherein the structural details of the building include walls and other partitions within the building.
20. The system of any of 11 to 19 wherein the site map file is one of a computer aided drafting file, a building information model file, a map file, or an image file.

## Claims

1. A method comprising:
receiving a site map file documenting a layout of a building, the site map file including at least structural details of the building and a respective placement of each of a plurality of devices within the building;
using the structural details and the respective placement of each of the plurality of devices identified from the site map file to generate a zone configuration subdividing the layout of the building into a plurality of zones;
identifying a respective specification for each of the plurality of devices;
generating a respective cause and effect logic file for each of the plurality of zones based on the respective specification for each of the plurality of devices and the respective placement of each of the plurality of devices with respect to each of the plurality of zones; and
transmitting the zone configuration and the respective cause and effect logic file for each of the plurality of zones to a control panel coupled to each of the plurality of devices.

2. The method of claim 1 further comprising displaying a graphical rendering of the site map file on a user interface device, the graphical rendering including an overlay illustrating each of the plurality of zones and a respective display of information contained within the respective cause and effects logic file for each of the plurality of zones, and the user interface device being one of a local thick client or a web based thin client.

3. The method of claim 2 further comprising receiving user input altering at least one of the zone configuration and the respective cause and effect logic file for at least one of the plurality of zones.

4. The method of claim 2 further comprising receiving user input confirming the zone configuration and the respective cause and effect logic file for each of the plurality of zones.

5. The method of claim 1 wherein the respective cause and effect logic file for a first of the plurality of zones links activation of an output type of the plurality of devices for which the respective placement is within a second of the plurality of zones with activation of an input type of the plurality of devices for which the respective placement is within the first of the plurality of zones.

6. The method of claim 5 wherein the second of the plurality of zones is a nearest one of the plurality of zones geographically to the first of the plurality of zones.

7. The method of claim 1 further comprising using security system standards data or fire alarm system standards data to generate the zone configuration and the respective cause and effect logic file for each of the plurality of zones.

8. The method of claim 1 further comprising receiving user input indicating a first real world scale for a portion of the site map file and extrapolating a second real world scale for all of the site map file from the first real world scale.

9. The method of claim 1 wherein the structural details of the building include walls and other partitions within the building.

10. The method of claim 1 wherein the site map file is one of a computer aided drafting file, a building information model file, a map file, or an image file.

11. A system comprising:
a plurality of devices deployed throughout a building;
a control panel coupled to each of the plurality of devices; and
a user interface device,
wherein the user interface device receives a site map file documenting a layout of the building,
wherein the site map file includes at least structural details of the building and a respective placement of each of the plurality of devices within the building,
wherein the user interface device uses the structural details and the respective placement of each of the plurality of devices identified from the site map file to generate a zone configuration subdividing the layout into a plurality of zones,
wherein the user interface device identifies a respective specification for each of the plurality of devices,
wherein the user interface device generates a respective cause and effect logic file for each of the plurality of zones based on the respective specification for each of the plurality of devices and the respective placement of each of the plurality of devices with respect to each of the plurality of zones, and
wherein the user interface device transmits the zone configuration and the respective cause and effect logic file for each of the plurality of zones to the control panel.

12. The system of claim 11 wherein the user interface device displays a graphical rendering of the site map file, the graphical rendering including an overlay illustrating each of the plurality of zones and a respective display of information contained within the respective cause and effect logic file for each of the plurality of zones, and wherein the user interface device includes one of a local thick client or a web based thin client.

13. The system of claim 12 wherein the user interface device receives user input altering at least one of the zone configuration and the respective cause and effect logic file for at least one of the plurality of zones.

14. The system of claim 12 wherein the user interface device receives user input confirming the zone configuration and the respective cause and effect logic file for each of the plurality of zones.

15. The system of claim 11 wherein the respective cause and effect logic file for a first of the plurality of zones links activation of an output type of the plurality of devices for which the respective placement is within a second of the plurality of zones with activation of an input type of the plurality of devices for which the respective placement is within the first of the plurality of zones.

## Amended claims

### Amended claims in accordance with Rule 137(2) EPC.

1. A method comprising:
receiving a site map file (102) documenting a layout of a building (22), the site map file (102) including at least structural details of the building (22) and a respective placement of each of a plurality of devices (28) within the building (22);
using the structural details and the respective placement of each of the plurality of devices (28) identified from the site map file (102) to automatically generate a zone configuration subdividing the layout of the building (22) into a plurality of zones (28) in response to receiving the site map file (102);
identifying a respective specification for each of the plurality of devices (28);
generating a respective cause and effect logic file automatically for each of the plurality of zones based on the respective specification for each of the plurality of devices (28) and the respective placement of each of the plurality of devices (28) with respect to each of the plurality of zones in response to receiving the site map file (102); and
transmitting the zone configuration and the respective cause and effect logic file for each of the plurality of zones (28) to a control panel (24) coupled to each of the plurality of devices (28).

2. The method of claim 1 further comprising displaying a graphical rendering of the site map (102) file on a user interface device (26), the graphical rendering including an overlay illustrating each of the plurality of zones and a respective display of information contained within the respective cause and effects logic file for each of the plurality of zones, and the user interface device (26) being one of a local thick client or a web based thin client.

3. The method of claim 2 further comprising receiving user input altering at least one of the zone configuration and the respective cause and effect logic file for at least one of the plurality of zones.

4. The method of claim 2 further comprising receiving user input confirming the zone configuration and the respective cause and effect logic file for each of the plurality of zones.

5. The method of claim 1 wherein the respective cause and effect logic file for a first of the plurality of zones links activation of an output type of the plurality of devices (28) for which the respective placement is within a second of the plurality of zones with activation of an input type of the plurality of devices (28) for which the respective placement is within the first of the plurality of zones.

6. The method of claim 5 wherein the second of the plurality of zones is a nearest one of the plurality of zones geographically to the first of the plurality of zones.

7. The method of claim 1 further comprising using security system standards data or fire alarm system standards data to generate the zone configuration and the respective cause and effect logic file for each of the plurality of zones.

8. The method of claim 1 further comprising receiving user input indicating a first real world scale for a portion of the site map file and extrapolating a second real world scale for all of the site map file (102) from the first real world scale.

9. The method of claim 1 wherein the structural details of the building include walls and other partitions within the building (22).

10. The method of claim 1 wherein the site map file (102) is one of a computer aided drafting file, a building information model file, a map file, or an image file.

11. A system comprising:
a plurality of devices (28) deployed throughout a building (22);
a control panel (24) coupled to each of the plurality of devices (28); and
a user interface device (24),
wherein the user interface device (24) receives a site map file (102) documenting a layout of the building (22),
wherein the site map file (102) includes at least structural details of the building (22) and a respective placement of each of the plurality of devices (28) within the building (22),
wherein the user interface device (26) uses the structural details and the respective placement of each of the plurality of devices (28) identified from the site map file (102) to automatically generate a zone configuration subdividing the layout into a plurality of zones in response to receiving the site map file (102),
wherein the user interface device (26) identifies a respective specification for each of the plurality of devices (28),
wherein the user interface device (26) automatically generates a respective cause and effect logic file for each of the plurality of zones based on the respective specification for each of the plurality of devices (28) and the respective placement of each of the plurality of devices (28) with respect to each of the plurality of zones in response to receiving the site map file (102), and
wherein the user interface device (26) transmits the zone configuration and the respective cause and effect logic file for each of the plurality of zones to the control panel (24).

12. The system of claim 11 wherein the user interface device (26) displays a graphical rendering of the site map file (102), the graphical rendering including an overlay illustrating each of the plurality of zones and a respective display of information contained within the respective cause and effect logic file for each of the plurality of zones, and wherein the user interface device (26) includes one of a local thick client or a web based thin client.

13. The system of claim 12 wherein the user interface device (26) receives user input altering at least one of the zone configuration and the respective cause and effect logic file for at least one of the plurality of zones.

14. The system of claim 12 wherein the user interface device (26) receives user input confirming the zone configuration and the respective cause and effect logic file for each of the plurality of zones.

15. The system of claim 11 wherein the respective cause and effect logic file for a first of the plurality of zones links activation of an output type of the plurality of devices (28) for which the respective placement is within a second of the plurality of zones with activation of an input type of the plurality of devices (28) for which the respective placement is within the first of the plurality of zones.
